# EUROPÄISCHE PATENTSCHRIFT

(11) **EP 2 296 942 B1**
(45) Veröffentlichungstag und Bekanntmachung des Hinweises auf die Patenterteilung: **19.07.2017**
(21) Anmeldenummer: 09772223.5
(22) Anmeldetag: 04.05.2009
(51) Int. Cl.: B60R 16/023

(54) **STEUERGERÄT FÜR PERSONENSCHUTZMITTEL FÜR EIN FAHRZEUG UND EIN VERFAHREN ZUM ZUSAMMENBAU EINES SOLCHEN STEUERGERÄTS**
CONTROL UNIT FOR PERSONAL PROTECTION MEANS FOR A VEHICLE AND A METHOD FOR ASSEMBLING SUCH A CONTROL UNIT
APPAREIL DE COMMANDE POUR MOYENS DE PROTECTION DES OCCUPANTS D'UN VÉHICULE À MOTEUR ET PROCÉDÉ D'ASSEMBLAGE D'UN APPAREIL DE COMMANDE DE CE TYPE

(30) Priorität: 03.07.2008 DE 102008040156
(43) Veröffentlichungstag der Anmeldung: 23.03.2011
(73) Patentinhaber: Robert Bosch GmbH, 70442 Stuttgart (DE)
(72) Erfinder: MOSER, Manfred, 72768 Reutlingen (DE); WONNER, Mark, 71672 Marbach Am Neckar (DE); CUPAL, Roland, 71706 Markgroeningen (DE)
(86) Internationale Anmeldenummer: PCT/EP2009/055358
(87) Internationale Veröffentlichungsnummer: WO 2010/000523

(56) Entgegenhaltungen:
- EP-A- 0 717 588
- EP-A- 1 263 274
- EP-B- 0 927 508
- WO-A-02/057118
- DE-A1- 19 836 887

## Beschreibung

### Stand der Technik

Die Erfindung betrifft ein Steuergerät für Personenschutzmittel für ein Fahrzeug bzw. ein entsprechendes Verfahren zum Zusammenbau eines solchen Steuergerätes nach der Gattung der unabhängigen Patentansprüche.

Aus der gattungsgemäßen EP 0 927 508 B1 ist es bekannt die Leiterplatte vor dem Einbau in das Fahrzeug mit dem Gehäusedeckel bzw. dem Gehäuseboden zu verschrauben.

Aus der WO 02/057118 A1 ist bekannt, ein Steuergerät für ein Kraftfahrzeug, das eine Grundplatte und einen mit der Grundplatte wärmeleitend und dichtend verbundenen Deckel aufweist. In dem von dem Deckel begrenzten Gehäuse des Steuergeräts sind zwei Schaltungsträger angeordnet. Der erste Schaltungsträger, welcher wärmeabgebende Bauelemente trägt, ist unmittelbar mit der Grundplatte verbunden, welche wiederum an eine Anbaufläche angekoppelt ist. Der zweite Schaltungsträger, welcher zumindest ein wärmeabgebendes, verdrahtetes Bauelement trägt, bildet zusammen mit dem Deckel eine vormontierbare Baueinheit aus. Das verdrahtete Bauelement ist über ein Wärmeleitmedium mit dem Deckel thermisch gekoppelt, welcher wiederum mit der Grundplatte verbunden ist. Das erfindungsgemäße Steuergerät ist besonders kompakt aufgebaut und ermöglicht eine gute Wärmeabfuhr insbesondere bei bezüglich der Umgebungstemperatur des Steuergeräts kritischen Einbauverhältnissen.

Aus der EP 1263 274 A2 ist bekannt, ein Steuergerät, das ein Gehäuse hat, welches ein Bodenteil und einen Deckel aufweist. Ein mit einer Leiterplatte verbundener Steckerkörper, der aus dem Gehäuse herausragt. Um in einem Übergangsbereich zwischen dem Bodenteil, dem Deckel und einer Zwischenwand des Steckerköpers eine gute Abdichtung des Gehäuses zu erzielen, wird vorgeschlagen, im Deckel eine Nut auszubilden, in der eine Dichtmasse angeordnet ist. Bei der Montage der Bauteile wird die Dichtmasse von der Zwischenwand in den Bereich einer auf dem Bodenteil angebrachten weiteren Dichtmasse verdrängt, wobei sich die beiden Dichtmassen in einem Überdeckungsbereich treffen.

### Offenbarung der Erfindung

Das erfindungsgemäße Steuergerät für Personenschutzmittel für ein Fahrzeug bzw. das erfindungsgemäße Verfahren zum Zusammenbau des Steuergeräts für Personenschutzmittel für ein Fahrzeug mit den Merkmalen der unabhängigen Patentansprüche haben demgegenüber den Vorteil, dass eine Vorfixierung der Leiterplatte mit dem Kunststoffboden und dem Kunststoffdeckel ohne Werkzeug ermöglicht wird. Damit ist kein vorheriges Einschrauben der Leiterplatte auf den Gehäuseboden bzw. in Verbindung mit dem Gehäusedeckel notwendig. Dies vereinfacht den Zusammenbau des Steuergeräts erheblich. Dafür ist eine Vorfixierung vorgesehen, die beispielsweise durch das bloße Zusammendrücken des Gehäusebodens, des Gehäusedeckels und der Leiterplatte realisiert wird. Die Verbindung kann formschlüssig und/oder kraftschlüssig ausgebildet sein. Entscheidend ist, dass kein Werkzeug notwendig ist. Weitere Vorteile sind die Kunststoffausführung des Deckels und des Bodens, die beide zusammen das Gehäuse ausmachen.

Beim Zusammenbau dieses erfindungsgemäßen Steuergeräts wird zunächst die Leiterplatte bestückt, beispielsweise mit SMD (Surface Mounted Device)-Bauteilen, um diese dann in einem Reflowlötprozess aufzulöten. Sodann wird durch das Zusammenstecken der Leiterplatte, des Kunststoffbodens und des Kunststoffdeckels die Vorfixierung erreicht, indem beispielsweise Clips das Gehäuse zusammenhalten. Der Kunststoffdeckel und der Kunststoffboden machen dabei zusammen das Gehäuse aus. Später wenn das Gehäuse für den Einbau genutzt werden soll, wird dann dieser Einbau beispielsweise mittels Schrauben, die sowohl durch den Kunststoffdeckel durch die Leiterplatte als auch durch den Kunststoffboden gehen, erreicht.

Vorliegend ist ein Steuergerät ein Gerät, das Sensorsignale verarbeitet und in Abhängigkeit davon Steuersignale erreicht. Unter Personenschutzmitteln ist wie gesagt ein Airbag, ein Gurtstraffer oder eine crashaktive Kopfstütze zu verstehen. Aber auch andere Personenschutzmittel wie der Fußgängerschutz, weitere Airbags usw. sind hierin zu verstehen.

Die Aufnahme von elektrischen Bauelementen auf die Leiterplatte bedeutet, dass verschiedenste elektrische bzw. elektronische Bauelemente auf der Leiterplatte aufgesetzt werden, um sie dann insbesondere in SMD-Technik zu befestigen. Es ist möglich, dass mehr als eine Leiterplatte verwendet wird. Die Leiterplatte stellt die elektrischen Bauelemente und auf ihr vorgesehene Verbindungen zwischen diesen Bauelementen zur Verfügung. Auch die Leiterplatte ist wie sie für herkömmliche elektronische Schaltungen verwendet wird, gestaltet.

Der Kunststoffdeckel und der Kunststoffboden sind aus einem Kunststoff, der einen EMV (Elektromagnetische Verträglichkeit)-Schutz bietet. Dabei können folgende Materialien verwendet werden: PBT-GF30 und PA66 GF30. Gegebenenfalls kann eine Beimischung für die Verbesserung von elektrischen Abschirmungseigenschaften vorgesehen sein, also eine bessere elektromagnetische Verträglichkeit.

Der Kunststoffdeckel und der Kunststoffboden des Gehäuses sind aufeinander abgestimmt, so dass sie im zusammengebauten Zustand ein Gehäuse darstellen.

Die kraft- und formschlüssige Verbindung sorgt für die Vorfixierung und benötigt zur Realisierung der kraft- und/oder formschlüssigen Verbindung kein Werkzeug.

Durch die in den abhängigen Ansprüchen aufgeführten Maßnamen und Weiterbildungen sind vorteilhaften Verbesserungen des In den unabhängigen Patentansprüchen angegebenen Steuergeräts bzw. Verfahrens zum Zusammenbau eines solchen Steuergeräts möglich.

Es ist dabei vorteilhaft, dass durch die Vorfixierung die Leiterplatte auch vorfixiert ist. D. h. die Vorfixierung betrifft nicht nur das Gehäuse, sondern auch den Inhalt des Gehäuses nämlich die Leiterplatte.

Vorteilhafter Weise kann für die wenigstens eine Verbindung eine Clips-Verbindung verwendet werden, um die Erfindung zu lösen.

Darüber hinaus ist es vorteilhaft, dass bei der Vorfixierung wenigstens ein Halter in wenigstens eine Leiterplatte in der vorfixierten Position hält. Der Halter kann dabei im Kunststoffdeckel und/oder im Kunststoffboden angebracht sein.

Der wenigstens eine Halter kann vorteilhafter Weise mit einer Federkraft ausgestattet sein, um die wenigstens eine Leiterplatte in der vorfixierten Position zu stützen bzw. zu drücken. Damit wird die Positionierung der Leiterplatte durch den Transport vom Werk des Steuergeräteherstellers bis zum Autohersteller zuverlässig gehalten.

Darüber hinaus ist es vorteilhaft, dass der wenigstens eine Halter federnd ausgebildet ist und mit einer entsprechenden Federkraft gegen die wenigstens eine Leiterplatte drückt, so dass die wenigstens eine Leiterplatte in der vorfixierten Stellung gehalten wird. Dies ist eine besonders effiziente Art und Weise, die Leiterplatte im Steuergerät gegen äußere Einflüsse zu schützen. Insbesondere die Stoßfestigkeit ist dadurch entscheidend erhöht worden. Wie der Halter federnd gestaltet ist, ist beliebig. Es kann insbesondere nur ein Teil des Halters federnd gestaltet sein.

Vorteilhafter Weise kann für den Halter im Kunststoffdeckel auch ein Gegenhalter im Kunststoffboden vorgesehen sein, um die Kraft aufzunehmen. Dies erhöht die Zuverlässigkeit des erfindungsgemäßen Steuergeräts. Dabei kann insbesondere der Halter im Kunststoffdeckel federnd ausgeführt sein, während der Gegenhalter am Kunststoffboden starr ausgeführt ist.

Vorteilhafter Weise ist der wenigstens eine Halter teilweise durch die Leiterplatte hindurchgeführt worden. Es muss dann ein entsprechender Anschlag vorgesehen sein, damit die Feder auch ihre entsprechenden Kräfte auf die Leiterplatte ausüben kann. Demnach ist der Anschlag so angeordnet, dass der Halter nicht mehr weiter durch die Leiterplatte durchführbar ist. Der Anschlag ist demnach größer als die Bohrung in der Leiterplatte, durch die der Halter hindurchragt. Insbesondere ist jedoch von Vorteil, dass der ganze Zusammenbau ohne Werkzeug möglich ist.

Es ist weiterhin vorteilhaft, dass die wenigstens eine Leiterplatte, Kunststoffdeckel und der Kunststoffboden so gestaltet sind, dass das Steuergerät durch wenigstens ein Verbindungselement in das Fahrzeug einbaubar ist. D. h. Kunststoffdeckel und Kunststoffboden weisen jeweils eine Buchse auf und die Leiterplatte zumindest eine Bohrung. Damit kann ein Verbindungselement wie eine Schraube, ein Bolzen oder eine Niete durch diese Durchführung hindurch, um die drei Elemente miteinander zu befestigen. Zusätzlich kann, wenn das Verbindungselement leitend ist, eine Masseverbindung zwischen der Leiterplatte und dem Fahrzeugchassis hergestellt werden.

Ausführungsbeispiel der Erfindung sind in der Zeichnung dargestellt und werden in der nachfolgenden Beschreibung näher erläutert.

Es zeigen
- Fig. 1: ein Blockschaltbild des erfindungsgemäßen Steuergeräts mit angeschlossenen Komponenten,
- Fig. 2: eine Ansicht ins Innere des Steuergeräts,
- Fig. 3: eine Schnittdarstellung des erfindungsgemäßen Steuergeräts,
- Fig. 4: die Kräfteverteilung,
- Fig. 5: eine weitere Schnittdarstellung des erfindungsgemäßen Steuergeräts und
- Fig. 6: ein Flussdiagramm des erfindungsgemäßen Verfahrens.

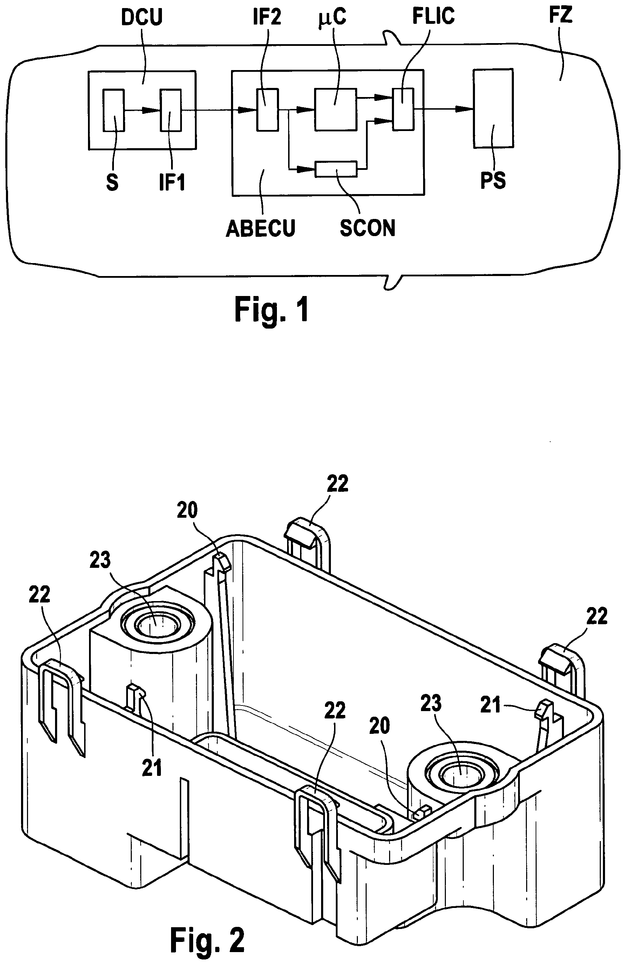

Fig. 1 zeigt in einem Blockschaltbild das erfindungsgemäße Steuergerät ABECU im Fahrzeug FZ mit angeschlossenen Komponenten Sensorsteuergerät DCU und Personenschutzmitteln PS. Vorliegend sind nur einige Bauelemente des Steuergeräts ABECU dargestellt. Vollständig sind die Schaltkreise komplexer und weisen mehr Bausteine auf.

Vorliegend werden Sensorsignale von der Sensorik S beispielsweise eine Beschleunigungssensorik im Sensorsteuergerät DCU über die Schnittstelle IF1 zum Steuergerät ABECU und dabei zur Schnittstelle IF2 im Steuergerät ABECU übertragen. Die Schnittstelle IF2 führt u. a. eine Konversion der Daten bezüglich des Datenformats vor, so dass diese Daten innerhalb des Steuergeräts ABECU übertragen werden können und zwar dabei zu einem Mikrocontroller µC und einem Safety Controller SCON. Diese Übertragung geht von der Schnittstelle IF2 aus, beispielsweise über den sogenannten SPI (Serial Peripherial Interface) Bus. Beide Controller rechnen jeweilige Auslösealgorithmen und die Ergebnisse werden dann von der Auswertelogik der Schaltung FLIC miteinander verglichen. Zeigt diese Auswertung auf einen Ansteuerungsfall hin, dann bestromt die Ansteuerungsschaltung FLIC Zündelemente der Personenschutzmittel PS, um eine pyrotechnische Auslösung der Personenschutzmittel zu gewährleisten. Weiterhin ist auch ein strombetriebenes Fahrzeug möglich, das umfangreiche elektrische Energiereserven zur Verfügung stellt. Entscheidend ist, dass sowohl der Mikrocontroller µC als auch der Safety Controller SCON unabhängig voneinander die Sensorsignale auswerten und auf eine Auslöseentscheidung entscheiden, wobei der Safety Controller SCON einfacher ausgestattet ist als der Mikrocontroller µC.

Fig. 2 zeigt perspektivisch die Ausgestaltung des Kunststoffhalters. Dabei weist der Kunststoffhalter Federn 20 bzw. 21 auf, die die Leiterplatte in Position halten sollen. Auch die Clips 22 sind zu sehen. Auch zu sehen sind die Buchsen 23, durch die dann Schrauben das Gehäuse mit dem Kraftfahrzeug kraftschlüssig verbinden. Die Gewinde sind im Fahrzeugchassis angeordnet Vorliegend werden vier Federn 20, 21 verwendet. Es ist möglich, weniger als diese vier Federn 20, 21 zu verwenden.

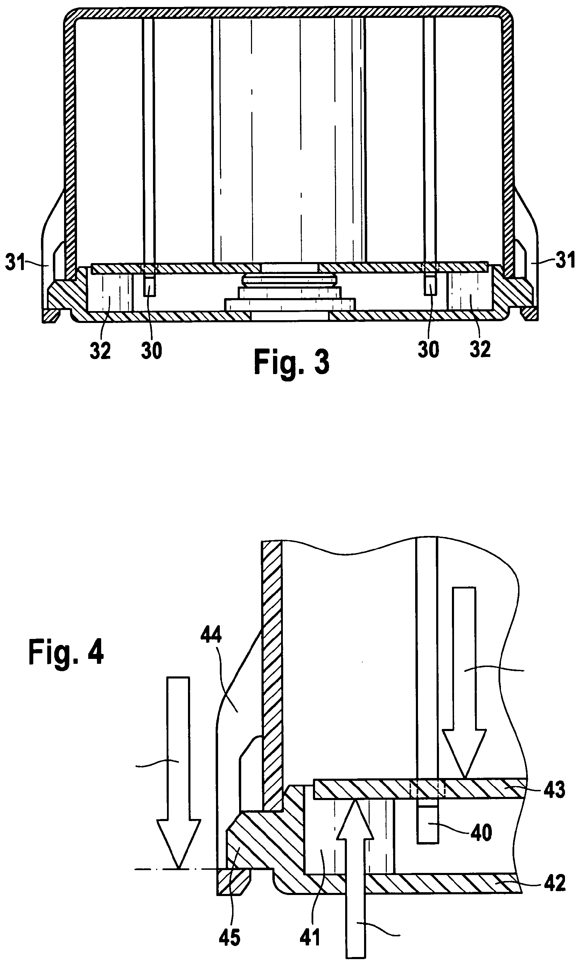

Fig. 3 zeigt in einer Schnittdarstellung das erfindungsgemäße Steuergerät mit zwei Federstäben 30, die gegen die Leiterplatte drücken wobei wiederum die Clips 31 zu sehen sind und auch die Gegenelemente 32 sowie die Federstäbe 30, die die Leiterplatte in Position halten.

Fig. 4 verdeutlicht die einwirkenden Kräfte. Aufgrund des Clips 44 wird die Clipkraft F_Clip des Clip auf das Steuergerätegehäuse ausgeübt. Aber auch der Federhalter 40 drückt mit der Kraft F_Feder gegen die Leiterplatte 43 und der Gegenhalter 41 mit der Gegenkraft F_Auflage. Gezeigt ist weiterhin ist weiterhin der Kunststoffboden 42 sowie ein Clipteil 45.

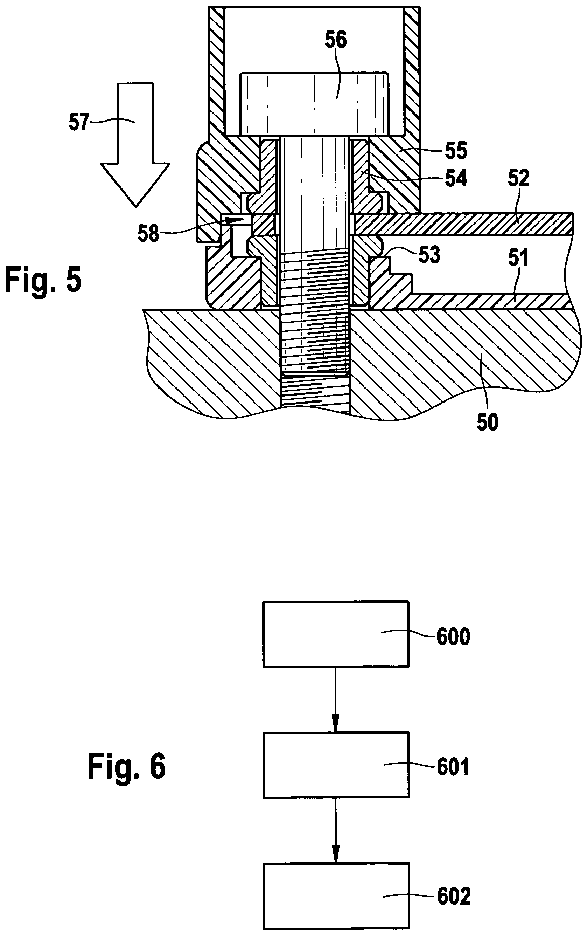

Fig. 5 zeigt eine weitere Schnittdarstellung des erfindungsgemäßen Steuergeräts. Vorliegend ist nur ein Ausschnitt dargestellt. Zu sehen ist ein Gehäusedeckel 55, die Schrauben bzw. der Stehbolzen 56 als Verbindungsmittel, die Relativbewegung aufgrund der Einpressbuchse und Gehäusedeckel, eine Leiterplattenklemmung 58 bzw. Fixierung, eine eingepresste Buchse 54, die die Verwendung der Schraube 56 ermöglicht, die Leiterplatte 52 sowie der Gehäuseboden 51. Mit dem Bezugszeichen 57 ist die Richtung bezeichnet, in der die Schraube geführt wird.

Fig. 6 zeigt in einem Flussdiagramm das erfindungsgemäße Verfahren. In Verfahrensschritt 600 wird die Leiterplatte mit elektrischen oder elektronischen Bauelementen bestückt. Im Verfahrensschritt 601 geschieht das Vorfixieren, indem die Clips verwendet werden beim Zusammenbau des Steuergeräts. Gemäß Verfahrensschritt 602 geschieht dann der Einbau am Fahrzeug, indem die entsprechenden Verbindungsmittel verwendet werden.

## Patentansprüche

1. Steuergerät für Personenschutzmittel (PS) für ein Fahrzeug (FZ) mit:
- wenigstens einer Leiterplatte (43, 52) für eine Aufnahme von elektronischen Bauelementen
- einem Deckel (55) und einem Boden (42, 51), zwischen denen die wenigstens eine Leiterplatt (43, 52) angeordnet ist, wobei der Deckel (55) und der Boden (42, 51) ein Gehäuse des Steuergeräts (ABECU) bilden, **dadurch gekennzeichnet, daß** der Deckel und der Boden aus Kunststoff sind und das Gehäuse für einen späteren Einbau durch wenigstens eine kraft- und/oder formschlüssige Verbindung vorfixierbar ist, wobei diese Verbindung ohne Werkzeug herstellbar ist.

2. Steuergerät nach Anspruch 1 **dadurch gekennzeichnet, dass** durch die Vorfixierung die Leiterplatte (43, 52) auch vorfixiert ist.

3. Steuergerät nach Anspruch 1 oder 2 **dadurch gekennzeichnet, dass** die wenigstens eine Verbindung ein Clip (44) ist.

4. Steuergerät nach Anspruch 2 oder 3 **dadurch gekennzeichnet, dass** bei der Vorfixierung wenigstens ein Halter (22, 21) die wenigstens eine Leiterplatte (43, 52) in einer vorfixierten Position hält, wobei der wenigstens eine Halter (22, 21) im Kunststoffdeckel (55) oder im Kunststoffboden (42, 51) angebracht ist.

5. Steuergerät nach Anspruch 4 **dadurch gekennzeichnet, dass** der wenigstens eine Halter (22, 21) federnd ausgebildet ist und mit einer entsprechenden Federkraft gegen die wenigstens eine Leiterplatte (43, 52) drückt, so dass die wenigstens eine Leiterplatte (43, 52) in der vorfixierten Position verbleibt.

6. Steuergerät nach Anspruch 4 oder 5 **dadurch gekennzeichnet, dass** der wenigstens eine Halter (22, 21) im Kunststoffdeckel (55) und im Kunststoffboden (42, 51) ein Gegenhalter (22, 21) angeordnet sind.

7. Steuergerät nach Anspruch 6 **dadurch gekennzeichnet, dass** der wenigstens eine Halter (22, 21) teilweise durch die Leiterplatte (43, 52) hindurchragt.

8. Steuergerät nach einem der vorhergehenden Ansprüche **dadurch gekennzeichnet, dass** die wenigstens eine Leiterplatte (43, 52), der Kunststoffdeckel (55) und der Kunststoffboden (42, 51) so gestaltet sind, dass das Steuergerät (ABECU) durch wenigstens ein Verbindungselement (56) in das Fahrzeug (FZ) einbaubar ist.

9. Steuergerät nach Anspruch 8 **dadurch gekennzeichnet, dass** aus wenigstens einem Verbindungselement (56) ein Anschluss der wenigstens einen Leiterplatte (43, 42) an die Fahrzeugmasse herstellt.

10. Verfahren zum Zusammenbau eines Steuergeräts für Personenschutzmittel (PS) für ein Fahrzeug (FZ) wobei wenigstens eine Leiterplatte (43, 52) für eine Aufnahme von elektrischen Bauelementen zwischen einem Deckel (55) und einem Boden (42, 51) angeordnet wird, wobei der Deckel (55) und der Boden (42, 51) das Gehäuse des Steuergeräts bilden, **dadurch gekennzeichnet, daß** der Deckel und der Boden aus Kunststoff sind und das Gehäuse für einen späteren Einbau durch wenigstens eine kraft- und/oder formschlüssige Verbindung vorfixiert ist, wobei die wenigstens eine Verbindung ohne Werkzeug hergestellt ist.

## Claims

1. Control unit for personal protection means (PS) for a vehicle (FZ), with:
- at least one printed circuit board (43, 52) for accommodating electronic components,
- a cover (55) and a base (42, 51), between which the at least one printed circuit board (43, 52) is arranged, wherein the cover (55) and the base (42, 51) form a housing of the control unit (ABECU), **characterized in that** the cover and the base are made from plastic, and the housing can be pre-fixed by at least one frictional and/or form-fitting connection for later installation, wherein said connection can be produced without a tool.

2. Control unit according to Claim 1, **characterized in that** the printed circuit board (43, 52) is also pre-fixed by the pre-fixing.

3. Control unit according to Claim 1 or 2, **characterized in that** the at least one connection is a clip (44).

4. Control unit according to Claim 2 or 3, **characterized in that**, during the pre-fixing, at least one holder (22, 21) holds the at least one printed circuit board (43, 52) in a pre-fixed position, wherein the at least one holder (22, 21) is fitted in the plastic cover (55) or in the plastic base (42, 51).

5. Control unit according to Claim 4, **characterized in that** the at least one holder (22, 21) is of resilient design and presses with a corresponding spring force against the at least one printed circuit board (43, 52) such that the at least one printed circuit board (43, 52) remains in the pre-fixed position.

6. Control unit according to Claim 4 or 5, **characterized in that** the at least one holder (22, 21) is arranged in the plastic cover (55) and a counter holder (22, 21) is arranged in the plastic base (42, 51).

7. Control unit according to Claim 6, **characterized in that** the at least one holder (22, 21) partially projects through the printed circuit board (43, 52).

8. Control unit according to one of the preceding claims, **characterized in that** the at least one printed circuit board (43, 52), the plastic cover (55) and the plastic base (42, 51) are designed in such a manner that the control unit (ABECU) can be installed in the vehicle (FZ) by means of at least one connecting element (56).

9. Control unit according to Claim 8, **characterized in that** a connection of the at least one printed circuit board (43, 42) to the vehicle mass is produced from at least one connecting element (56).

10. Method for assembling a control unit for personal protection means (PS) for a vehicle (FZ), wherein at least one printed circuit board (43, 52) for accommodating electric components is arranged between a cover (55) and a base (42, 51), wherein the cover (55) and the base (42, 51) form the housing of the control unit, **characterized in that** the cover and the base are made from plastic, and the housing is pre-fixed by at least one frictional and/or form-fitting connection for later installation, wherein the at least one connection is produced without a tool.

## Revendications

1. Appareil de commande destiné à des moyens de protection des occupants (PS) d'un véhicule (FZ) comportant :
- au moins une carte de circuit imprimé (43, 52) destinée à recevoir des composants électroniques,
- un couvercle (55) et un fond (42, 51) entre lesquels est disposée au moins une carte de circuit imprimé (43, 52), dans lequel le couvercle (55) et le fond (42, 51) forment un boîtier de l'appareil de commande (ABECU), **caractérisé en ce que** le couvercle et le fond sont constitués de matière plastique, et **en ce que** le boîtier peut être fixé à l'avance à des fins d'intégration ultérieure par au moins une liaison par complémentarité de force et/ou de forme, dans lequel ladite liaison peut être réalisée sans outil.

2. Appareil de commande selon la revendication 1, **caractérisé en ce que** la carte de circuit imprimé (43, 52) est également fixée à l'avance au moyen de la fixation à l'avance.

3. Appareil de commande selon la revendication 1 ou 2, **caractérisé en ce que** l'au moins une liaison est un clip (44).

4. Appareil de commande selon la revendication 2 ou 3, **caractérisé en ce que**, lors de la fixation à l'avance, au moins un support (22, 21) maintient l'au moins une carte de circuit imprimé (43, 52) à une position fixée à l'avance, dans lequel l'au moins un support (22, 21) est mis en place dans le couvercle de matière plastique (55) ou dans le fond de matière plastique (42, 51).

5. Appareil de commande selon la revendication 4, **caractérisé en ce que** l'au moins un support (22, 21) est réalisé de manière souple et exerce une pression avec une force de ressort correspondante sur l'au moins une carte de circuit imprimé (43, 52), de manière à ce que l'au moins une carte de circuit imprimé (43, 52) reste à la position fixée à l'avance.

6. Appareil de commande selon la revendication 4 ou 5, **caractérisé en ce que** l'au moins un support (22, 21) est disposé dans le couvercle de matière plastique (55) et **en ce qu'**un contre-support (22, 21) est disposé dans le fond de matière plastique (42, 51).

7. Appareil de commande selon la revendication 6, **caractérisé en ce que** l'au moins un support (22, 21) fait saillie partiellement à travers la carte de circuit imprimé (43, 52).

8. Appareil de commande selon l'une quelconque des revendications précédentes, **caractérisé en ce que** l'au moins une carte de circuit imprimé (43, 52), le couvercle de matière plastique (55) et le fond de matière plastique (42, 51) sont conçus de manière à ce que l'appareil de commande (ABECU) puisse être intégré au véhicule (FZ) à l'aide d'au moins un élément de liaison (56).

9. Appareil de commande selon la revendication 8, **caractérisé en ce qu'**une connexion de l'au moins une carte de circuit imprimé (43, 42) à la masse du véhicule est réalisée à partir d'au moins un élément de liaison (56).

10. Procédé d'assemblage d'un appareil de commande destiné à des moyens de protection des occupants (PS) d'un véhicule (FZ), dans lequel au moins une carte de circuit imprimé (43, 52) destinée à recevoir des composants électriques est disposée entre un couvercle (55) et un fond (42, 51), dans lequel le couvercle (55) et le fond (42, 51) forment le boîtier de l'appareil de commande, **caractérisé en ce que** le couvercle et le fond sont constitués de matière plastique et **en ce que** le boîtier est fixé à l'avance à des fins d'intégration ultérieure par au moins une liaison par complémentarité de force et/ou de forme, dans lequel l'au moins une liaison est réalisée sans outil.
